# EUROPÄISCHE PATENTSCHRIFT

(11) **EP 2 626 964 B1**
(45) Veröffentlichungstag und Bekanntmachung des Hinweises auf die Patenterteilung: **31.03.2021**
(21) Anmeldenummer: 12006870.5
(22) Anmeldetag: 04.10.2012
(51) Int. Cl.: H02H 3/17, B60L 3/04, G01R 27/18, G01R 31/12, H02H 5/10, H02H 11/00, G01R 31/00, B60L 3/00, B60L 58/21, H02H 7/26

(54) **Hochspannungsssystem und entsprechendes Überwachungsverfahren**
High voltage system and corresponding monitoring method
Système haute tension et procédé de surveillance correspondant

(30) Priorität: 07.02.2012 DE 102012002367
(43) Veröffentlichungstag der Anmeldung: 14.08.2013
(73) Patentinhaber: MAN Truck & Bus SE, 80995 München (DE)
(72) Erfinder: Soboll, Stefan, 85221 Dachau (DE); Kratzer, Sebastian, 80997 München (DE)
(74) Vertreter: v. Bezold & Partner Patentanwälte - PartG mbB

(56) Entgegenhaltungen:
- DE-A1-102009 002 991
- DE-A1-102010 031 456
- KR-A- 20080 030 753
- US-A1- 2009 219 656

## Beschreibung

Die Erfindung betrifft ein Hochspannungssystem, insbesondere in einem Kraftfahrzeug, und ein entsprechendes Überwachungsverfahren.

In modernen Nutzfahrzeugen werden zunehmend Hochspannungssysteme eingesetzt, die mehrere hochspannungsführende Hochspannungskomponenten aufweisen. Hierbei ist es wichtig, dass die Hochspannungskomponenten einen ausreichenden Isolationswiderstand gegenüber Masse aufweisen. Es ist deshalb bekannt, den Isolationswiderstand der Hochspannungskomponenten durch ein Isolationsmessgerät zu messen, wobei eine Überwachungseinheit den gemessenen Isolationswiderstand überwacht. Bisher wurde der Messwert des Isolationswiderstands jedoch nur in relativ großen Zeitabständen gemessen. Darüber hinaus erfolgte bisher unabhängig von dem Messwert des Isolationswiderstands keine Abschaltung der Hochspannungskomponenten.

Aus der US 2009/0219656 A1 ist ein System zur Überwachung eines elektrischen Systems bekannt, das eine fortwährende oder periodische Messung eines Isolationsparameters offenbart. Aus der KR 2008 0030753 A ist ein Sicherheitssystem zur Verhinderung von elektrischen Schlägen von Hochvoltfahrzeugen bekannt, wobei ebenfalls eine fortlaufende Echtzeitmessung eines Isolationswiderstands offenbart ist. Ferner offenbart die DE 10 2010 031 456 A1 ein Verfahren zur sicherheitsbedingten Abschaltung eines elektrischen Netzes, an dem mehrere elektrische Komponenten angeschlossen sind. Hierbei wird vorgeschlagen, Antriebsdaten mindestens einer der elektrischen Komponenten durch mindestens eine Überwachungseinheit zu überwachen. Hierbei wird eine Sicherheitsleitungsschleife unterbrochen, wenn auf Grundlage der Betriebsdaten durch die Überwachungseinheit eine sicherheitskritische Situation festgestellt wird.

Der Erfindung liegt deshalb die Aufgabe zugrunde, die bekannten Hochspannungssysteme entsprechend zu verbessern. Weiterhin liegt der Erfindung die Aufgabe zugrunde, ein entsprechendes Überwachungsverfahren anzugeben.

Diese Aufgabe wird durch ein erfindungsgemäßes Hochspannungssystem bzw. durch ein erfindungsgemäßes Überwachungsverfahren gemäß den unabhängigen Ansprüchen gelöst.

Die Erfindung umfasst die allgemeine technische Lehre, dass das Isolationsmessgerät den Isolationswiderstand im Betrieb laufend in kurzen Zeitabständen von weniger als 90 Sekunden misst, wobei die Überwachungseinheit die Hochspannungskomponenten abschaltet, wenn der gemessene Isolationswiderstand einen vorgegebenen Minimalwert unterschreitet, was auf eine Isolationsstörung schließen lässt.

Ferner sind die Überwachungseinheit und die einzelnen Hochspannungskomponenten durch eine ringförmige Überwachungsleitung miteinander verbunden, wobei diese Überwachungsleitung auch als Interlock-Signalleitung bezeichnet werden kann. Die ringförmige Überwachungsleitung geht hierbei von der Überwachungseinheit aus und verläuft nacheinander durch die einzelnen Hochspannungskomponenten und schließlich zu der Überwachungseinheit. Im Betrieb sendet die Überwachungseinheit ein Abfragesignal über die ringförmige Überwachungsleitung zu den einzelnen Hochspannungskomponenten, so dass das gesendete Abfragesignal nach dem Durchlaufen der einzelnen Hochspannungskomponenten schließlich wieder bei der Überwachungseinheit eingeht, sofern die Überwachungsleitung nicht unterbrochen ist. Die Überwachungseinheit überprüft dann laufend, ob das von der Überwachungseinheit gesendete Abfragesignal nach dem Passieren der ringförmigen Überwachungsleitung wieder von der Überwachungseinheit empfangen wird, was auf eine intakte Überwachungsleitung schließen lässt. Falls die Überwachungseinheit das Abfragesignal jedoch nicht wieder empfängt, so lässt dies auf eine Unterbrechung der Überwachungsleitung schließen, was beispielsweise durch eine Unterbrechung einer Hochspannungsleitung oder durch eine nicht gesteckte Hochspannungssteckverbindung verursacht werden kann. In einem solchen Fall schaltet die Überwachungseinheit die Hochspannungskomponenten ab, um einen Störfall zu vermeiden.

In dem bevorzugten Ausführungsbeispiel der Erfindung sind die einzelnen Hochspannungskomponenten jeweils durch eine Hochspannungssteckverbindung an eine Hochspannungsleitung angeschlossen, was an sich aus dem Stand der Technik bekannt ist. Die Überwachungsleitung ist hierbei vorzugsweise durch die Hochspannungssteckverbindung hindurchgeführt, so dass die Überwachungsleitung unterbrochen ist, wenn zumindest eine der Hochspannungssteckverbindungen getrennt ist. Die Durchführung der Überwachungsleitung durch die einzelnen Hochspannungssteckverbindungen ermöglicht es also der Überwachungseinheit, zu überprüfen, ob die Hochspannungssteckverbindungen gesteckt sind oder nicht. Die Hochspannung für die verschiedenen Hochspannungskomponenten wird dann von der Überwachungseinheit nur freigegeben, wenn sämtliche Hochspannungssteckverbindungen gesteckt sind.

Erfindungsgemäß sind die einzelnen Hochspannungskomponenten durch Kabelstränge miteinander verbunden, wobei die Kabelstränge jeweils eine Hochspannungsleitung und die Überwachungsleitung enthalten. Hierbei ist die Überwachungsleitung so durch die Kabelstränge zwischen den Hochspannungskomponenten hindurchgeführt, dass eine fehlerbedingte Trennung der Kabelstränge auch zu einer Trennung der Überwachungsleitung führt, was von der Überwachungseinheit erkannt wird, da das von der Überwachungseinheit ausgesandte Abfragesignal wegen der unterbrochenen Überwachungsleitung nicht wieder zu der Überwachungseinheit zurückgeführt wird.

Es wurde bereits vorstehend ausgeführt, dass das Isolationsmessgerät den Isolationswiderstand der einzelnen Hochspannungskomponenten laufend in kurzen Zeitabständen von weniger als 90 Sekunden misst. Vorzugsweise erfolgt die Isolationsmessung sogar wesentlich häufiger in einem Zeitabstand von weniger als 60 Sekunden oder sogar in einem Zeitabstand von weniger als 30 Sekunden.

Weiterhin ist zu erwähnen, dass das Abschalten der Hochspannungskomponenten vorzugsweise so schnell erfolgt, dass die Hochspannung innerhalb von weniger als 60 Sekunden auf weniger als 60 V abgebaut wird.

Ferner ist zu erwähnen, dass die Erfindung nicht auf das vorstehend beschriebene erfindungsgemäße Hochspannungssystem beschränkt ist, sondern auch ein Kraftfahrzeug (z.B. ein Nutzfahrzeug) umfasst, das mit einem solchen Hochspannungssystem ausgestattet ist.

Schließlich umfasst die Erfindung auch ein entsprechendes Überwachungsverfahren, wie sich bereits aus der vorstehenden Beschreibung ergibt, so dass hinsichtlich des Überwachungsverfahrens auf die vorstehende Beschreibung verwiesen wird.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine schematische Darstellung eines erfindungsgemäßen Hochspannungssystems, sowie
- Figur 2: das erfindungsgemäße Überwachungsverfahren in Form eines Flussdiagramms.

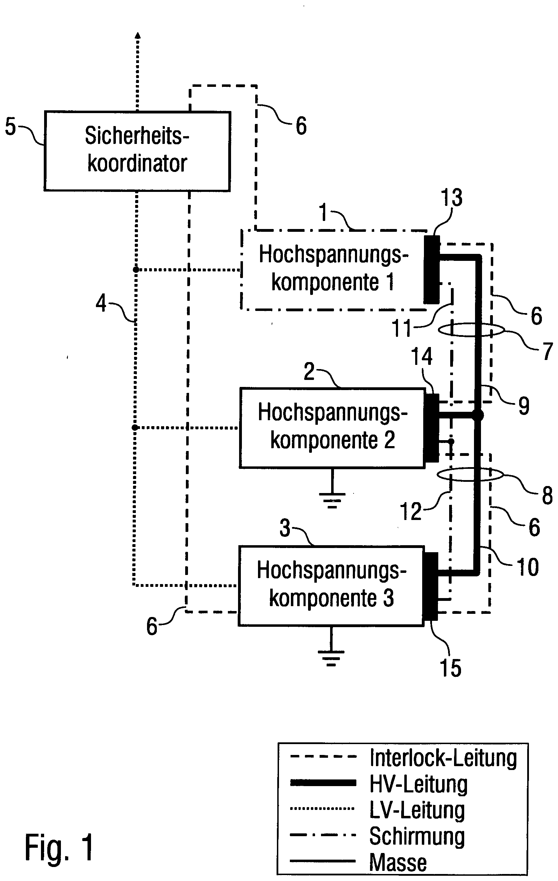

Figur 1 zeigt ein erfindungsgemäßes Hochspannungssystem, das in einem Nutzfahrzeug (z.B. Lastkraftwagen) eingesetzt werden kann.

Das erfindungsgemäße Hochspannungssystem weist mehrere Hochspannungskomponenten 1, 2, 3 auf, die in der Zeichnung lediglich schematisch dargestellt sind. Beispielsweise kann es sich bei den Hochspannungskomponenten 1-3 um Sensoren bzw. Aktoren handeln, jedoch ist die Erfindung hinsichtlich der technischen Funktion der Hochspannungskomponenten nicht auf diese Funktionen beschränkt.

In die Hochspannungskomponenten 1-3 ist jeweils ein Isolationsmessgerät integriert, das zur Vereinfachung nicht dargestellt ist. Das integrierte Isolationsmessgerät misst jeweils den Isolationswiderstand zwischen den hochspannungsführenden Bauteilen der Hochspannungskomponenten 1-3 einerseits und Masse andererseits. Der gemessene Isolationswiderstand wird über eine Niederspannungsleitung 4 ("LV-Leitung") an eine Überwachungseinheit 5 ("Sicherheitskoordinator") übertragen, wobei die Überwachungseinheit 5 überprüft, ob der gemessene Wert des Isolationswiderstands der einzelnen Hochspannungskomponenten 1-3 ausreicht oder auf einen Fehlerfall schließen lässt. Falls der gemessene Wert des Isolationswiderstands zu niedrig ist, so schaltet die Überwachungseinheit 5 die einzelnen Hochspannungskomponenten 1-3 über die Niederspannungsleitung 4 ab.

Darüber hinaus weist das erfindungsgemäße Hochspannungssystem eine Überwachungsleitung 6 ("Interlock-Signalleitung") auf, wobei die Überwachungsleitung 6 die Überwachungseinheit 5 ringförmig mit den Hochspannungskomponenten 1-3 verbindet.

Hierbei ist zu erwähnen, dass die Hochspannungskomponenten 1-3 durch Kabelstränge 7, 8 miteinander verbunden sind, wobei die Kabelstränge 7, 8 jeweils eine Hochspannungsleitung 9 bzw. 10, eine Schirmungsleitung 11 bzw. 12 und die Überwachungsleitung 6 enthalten. Die Überwachungsleitung 6 ist also durch die beiden Kabelstränge 7, 8 zwischen den Hochspannungskomponenten 1-3 hindurchgeführt, so dass eine fehlerbedingte Trennung der Kabelstränge 7 oder 8 auch zu einer Trennung der Überwachungsleitung 6 führt. Zur Erkennung einer derartigen Trennung der Kabelstränge 7 oder 8 sendet die Überwachungseinheit 5 ein Abfragesignal über die Überwachungsleitung 6, wobei das Abfragesignal im normalen Betrieb nach dem Passieren der Hochspannungskomponenten 1-3 wieder bei der Überwachungseinheit 5 eingeht, woran die Überwachungseinheit 5 erkennen kann, dass die Kabelstränge 7, 8 intakt sind. Falls das Abfragesignal dagegen nicht wieder bei der Überwachungseinheit 5 eingeht, so geht die Überwachungseinheit 5 davon aus, dass zumindest einer der Kabelstränge 7, 8 durchtrennt ist, woraufhin die Überwachungseinheit 5 die Hochspannungskomponenten 1-3 über die Niederspannungsleitung 4 abschaltet.

Weiterhin ist zu erwähnen, dass die Hochspannungsleitungen 9, 10 über jeweils eine Hochspannungssteckverbindung 13-15 mit den Hochspannungskomponenten 1-3 verbunden sind. Die Überwachungsleitung 6 ist hierbei so durch die Hochspannungssteckverbindungen 13-15 hindurchgeführt, dass die Überwachungsleitung 6 automatisch unterbrochen wird, wenn zumindest eine der Hochspannungssteckverbindungen 13-15 nicht gesteckt ist. Die Überwachungseinheit 5 kann also über eine entsprechende Abfrage über die Überwachungsleitung 6 auch erkennen, ob die Hochspannungssteckverbindungen 13-15 gesteckt sind oder nicht. Falls diese Überprüfung ergibt, dass zumindest eine der Hochspannungssteckverbindungen 13-15 nicht gesteckt ist, so schaltet die Überwachungseinheit 5 die Hochspannungskomponenten 1-3 über die Niederspannungsleitung 4 ab, um einen sicheren Betrieb zu gewährleisten.

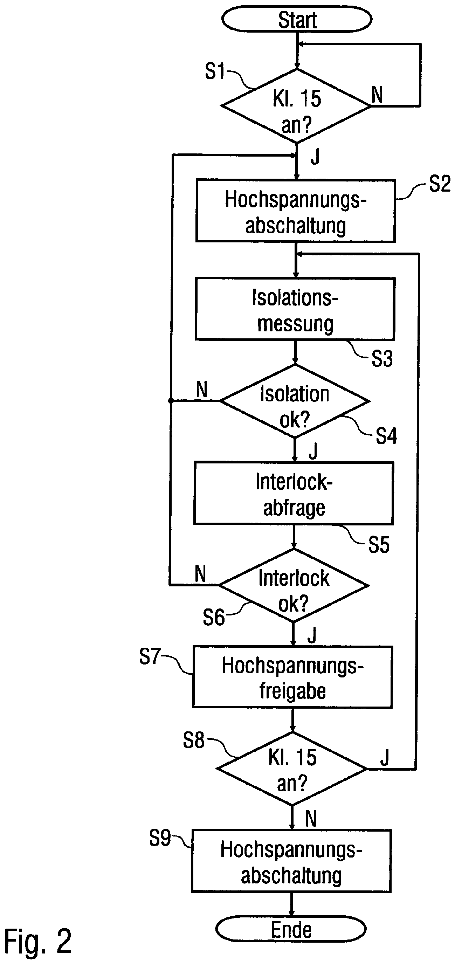

Im Folgenden wird nun anhand des Flussdiagramms in Figur 2 das erfindungsgemäße Überwachungsverfahren für das vorstehend beschriebene Hochspannungssystem erläutert.

In einem ersten Schritt S1 wird zunächst geprüft, ob die Klemme 15 des Bordnetzes des Nutzfahrzeugs Spannung führt. Es wird also überprüft, ob das Bordnetz des Nutzfahrzeugs angeschaltet ist. Diese Überprüfung wird so lange wiederholt, bis in dem Schritt S1 festgestellt wird, dass an der Klemme 15 des Bordnetzes Spannung anliegt.

Anschließend erfolgt dann in einem Schritt S2 zunächst eine Hochspannungsabschaltung, d.h. die Überwachungseinheit 5 schaltet die Hochspannungskomponenten 1-3 über die Niederspannungsleitung 4 ab.

In einem Schritt S3 erfolgt dann - wie vorstehend beschrieben - eine Isolationsmessung, d.h. das in die Hochspannungskomponenten 1-3 integrierte Isolationsmessgerät misst den jeweiligen Isolationswiderstand.

In einem Schritt S4 wird dann überprüft, ob die jeweilige Isolation ausreichend ist.

Falls dies nicht der Fall ist, so wird zu dem Schritt S2 übergegangen, woraufhin die Hochspannungskomponenten 1-3 abgeschaltet werden.

Falls die Überprüfung in dem Schritt S4 dagegen einen ausreichenden Isolationswiderstand ergibt, so erfolgt in einem Schritt S5 die vorstehend beschriebene Interlock-Abfrage über die Überwachungsleitung 6, um zu überprüfen, ob sämtliche Hochspannungssteckverbindungen 13-15 gesteckt sind und ob keiner der Kabelstränge 7, 8 unterbrochen ist.

Falls dies nicht der Fall sein sollte, so wird ebenfalls zu dem Schritt S2 übergegangen, woraufhin die Hochspannungskomponenten 1-3 abgeschaltet werden.

Falls dagegen sowohl die Isolationsmessung als auch die Interlock-Abfrage fehlerfrei verlaufen, so wird zu einem Schritt S7 übergegangen, in dem die Hochspannung der Hochspannungskomponenten 1-3 freigegeben wird.

Anschließend wird dann in einem Schritt S8 wieder überprüft, ob an der Klemme 15 Spannung anliegt.

Falls dies nicht der Fall sein sollte, so wird in einem letzten Schritt S9 die Hochspannung der Hochspannungskomponenten 1-3 abgeschaltet.

Andernfalls wird dagegen wieder zu dem Schritt S3 übergegangen, wo eine Isolationsmessung stattfindet.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls in den Schutzbereich der Hauptansprüche fallen. Darüber hinaus beansprucht die Erfindung auch Schutz für den Gegenstand und die Merkmale der Unteransprüche.

## Patentansprüche

1. Hochspannungssystem, insbesondere in einem Kraftfahrzeug, mit
a) mehreren Hochspannungskomponenten (1-3), die jeweils eine elektrische Hochspannung führen,
b) mehreren Isolationsmessgeräten, die jeweils ausgebildet sind, einen Isolationswiderstand zwischen einer der Hochspannungskomponenten (1-3) und Masse zu messen, und
c) mindestens einer Überwachungseinheit (5) zur Überwachung des Isolationswiderstands der Hochspannungskomponenten (1-3), wobei
d) jedes Isolationsmessgerät ausgebildet ist, den Isolationswiderstand laufend in kurzen Zeitabständen von weniger als 90 Sekunden zu messen, und
e) die Überwachungseinheit (5) ausgebildet ist, die Hochspannungskomponenten (1-3) abzuschalten, wenn der gemessene Isolationswiderstand einen vorgegebenen Minimalwert unterschreitet,
**dadurch gekennzeichnet,**
f) **dass** eine ringförmige Überwachungsleitung (6) vorgesehen ist, die von der Überwachungseinheit (5) ausgeht und diese nacheinander mit den einzelnen Hochspannungskomponenten (1-3) verbindet und schließlich zu der Überwachungseinheit (5) zurückgeführt ist,
g) **dass** die Überwachungseinheit (5) ausgebildet ist, ein Abfragesignal über die ringförmige Überwachungsleitung (6) zu senden,
h) **dass** die Überwachungseinheit (5) ausgebildet ist, zu überprüfen, ob das von der Überwachungseinheit (5) gesendete Abfragesignal nach dem Passieren der ringförmigen Überwachungsleitung (6) wieder von der Überwachungseinheit (5) empfangen wird,
i) **dass** die Überwachungseinheit (5) ausgebildet ist, die Hochspannungskomponenten (1-3) abzuschalten, wenn die Überwachungseinheit (5) das Abfragesignal nicht empfängt,
j) **dass** die Hochspannungskomponenten (1-3) durch Kabelstränge (7, 8) miteinander verbunden sind, wobei die Kabelstränge (7, 8) jeweils eine Hochspannungsleitung (9, 10) und die Überwachungsleitung (6) enthalten, und
k) **dass** die Überwachungsleitung (6) so durch die Kabelstränge (7, 8) zwischen den Hochspannungskomponenten (1-3) hindurchgeführt ist, dass eine fehlerbedingte Trennung der Kabelstränge (7, 8) auch zu einer Trennung der Überwachungsleitung (6) führt.

2. Hochspannungssystem nach Anspruch 1, **dadurch gekennzeichnet,**
a) **dass** die Hochspannungskomponenten (1-3) jeweils durch eine Hochspannungssteckverbindung (13-15) an eine Hochspannungsleitungen (9, 10) angeschlossen sind, und
b) **dass** die Überwachungsleitung (6) durch die Hochspannungssteckverbindungen (13-15) so hindurchgeführt ist, dass die Überwachungsleitung (6) unterbrochen ist, wenn zumindest eine der Hochspannungssteckverbindungen (13-15) getrennt ist.

3. Hochspannungssystem nach einem der vorhergehenden Ansprüche, **dadurch gekennzeichnet,**
a) **dass** jedes Isolationsmessgerät ausgebildet ist, den Isolationswiderstand laufend in kurzen Zeitabständen von weniger als 60 oder 30 Sekunden zu messen, und/oder
b) **dass** beim Abschalten der Hochspannungskomponenten (1-3) die Hochspannung innerhalb von weniger als 60 Sekunden auf weniger als 60V abgebaut wird.

4. Kraftfahrzeug, insbesondere Nutzfahrzeug, mit einem Hochspannungssystem nach einem der vorhergehenden Ansprüche.

5. Überwachungsverfahren für ein Hochspannungssystem, insbesondere für ein Hochspannungssystem nach einem der vorhergehenden Ansprüche, mit den folgenden Schritten:
a) Messung eines Isolationswiderstands gegenüber Masse von Hochspannungskomponenten (1-3) des Hochspannungssystems,
b) Überwachen des gemessenen Isolationswiderstands der einzelnen Hochspannungskomponenten (1-3) des Hochspannungssystems durch eine Überwachungseinheit (5), wobei
c) der Isolationswiderstand der einzelnen Hochspannungskomponenten (1-3) laufend in kurzen Zeitabständen von weniger als 90 Sekunden durch entsprechende Isolationsmessgeräte gemessen wird, und
d) die Überwachungseinheit (5) die Hochspannungskomponenten (1-3) abschaltet, wenn der gemessene Isolationswiderstand einen vorgegebenen Minimalwert unterschreitet.
**dadurch gekennzeichnet,**
e) **dass** eine ringförmige Überwachungsleitung (6) vorgesehen ist, die von der Überwachungseinheit (5) ausgeht und diese nacheinander mit den einzelnen Hochspannungskomponenten (1-3) verbindet und schließlich zu der Überwachungseinheit (5) zurückgeführt ist,
f) **dass** die Überwachungseinheit (5) ein Abfragesignal über die ringförmige Überwachungsleitung (6) sendet,
g) **dass** die Überwachungseinheit (5) überprüft, ob das von der Überwachungseinheit (5) gesendete Abfragesignal nach dem Passieren der ringförmigen Überwachungsleitung (6) wieder von der Überwachungseinheit (5) empfangen wird,
h) **dass** die Überwachungseinheit (5) die Hochspannungskomponenten (1-3) abschaltet, wenn die Überwachungseinheit (5) das Abfragesignal nicht empfängt.
i) **dass** die Hochspannungskomponenten (1-3) durch Kabelstränge (7, 8) miteinander verbunden sind, wobei die Kabelstränge (7, 8) jeweils eine Hochspannungsleitung (9, 10) und die Überwachungsleitung (6) enthalten, und
j) **dass** die Überwachungsleitung (6) so durch die die Kabelstränge (7, 8) zwischen den Hochspannungskomponenten (1-3) hindurchgeführt ist, dass eine fehlerbedingte Trennung der Kabelstränge (7, 8) auch zu einer Trennung der Überwachungsleitung (6) führt.

6. Überwachungsverfahren nach Anspruch 5, **dadurch gekennzeichnet,**
a) **dass** die Hochspannungskomponenten (1-3) jeweils durch eine Hochspannungssteckverbindung (13-15) an eine Hochspannungsleitung (9, 10) angeschlossen sind, und
b) **dass** die Überwachungsleitung (6) durch die Hochspannungssteckverbindungen (13-15) so hindurchgeführt ist, dass die Überwachungsleitung (6) unterbrochen ist, wenn zumindest eine der Hochspannungssteckverbindungen (13-15) getrennt ist.

7. Überwachungsverfahren nach einem der Ansprüche 5 bis 6,
**dadurch gekennzeichnet,**
a) **dass** das Isolationsmessgerät den Isolationswiderstand laufend in kurzen Zeitabständen von weniger als 60 oder 30 Sekunden misst, und/oder
b) **dass** beim Abschalten der Hochspannungskomponenten (1-3) die Hochspannung innerhalb von weniger als 60 Sekunden auf weniger als 60V abgebaut wird.

## Claims

1. A high voltage system, in particular in a motor vehicle, having
a) a plurality of high voltage components (1-3) that case carry an electrical high voltage,
b) a plurality of insulation measuring devices that are each designed to measure an insulation resistance between one of the high voltage components (1-3) and earth, and
c) at least one monitoring unit (5) for monitoring the insulation resistance of the high voltage components (1-3), wherein
d) each insulation measuring device is designed to measure the insulation resistance routinely at short time intervals of less than 90 seconds, and
e) the monitoring unit (5) is designed to switch off the high voltage components (1-3) if the measured insulation resistance is below a predetermined minimum value,
**characterized**
f) **in that** a ring-like monitoring line (6) is provided that issues from the monitoring unit (5) and sequentially connects the latter to the individual high voltage components (1-3) and finally is returned to the monitoring unit (5),
g) **in that** the monitoring unit (5) is designed to transmit a query signal by way of the ring-like monitoring line (6),
h) **in that** the monitoring unit (5) is designed to check whether the query signal that is transmitted by the monitoring unit (5) after passing along the ring-like monitoring line (6) is received again by the monitoring unit (5),
i) **in that** the monitoring unit (5) is designed to switch off the high voltage components (1-3) if the monitoring unit (5) does not receive the query signal,
j) **in that** the high voltage components (1-3) are connected to one another by wiring harnesses (7, 8), wherein the wiring harnesses (7, 8) each contain a high voltage line (9, 10) and the monitoring line (6), and
k) **in that** the monitoring line (6) is routed through the wiring harnesses (7, 8) between the high voltage components (1-3), so that a fault-related disconnection of the wiring harnesses (7, 8) also results in disconnection of the monitoring line (6).

2. The high voltage system according to Claim 1, **characterized**
a) **in that** the high voltage components (1-3) are each connected by a high voltage plug connection (13-15) to a high voltage line (9, 10), and
b) **in that** the monitoring line (6) is routed through the high voltage plug connections (13-15), so that the monitoring line (6) is broken if at least one of the high voltage plug connections (13-15) is disconnected.

3. The high voltage system according to any one of the preceding claims, **characterized**
a) **in that** each insulation measuring device is designed to measure the insulation resistance routinely at short time intervals of less than 60 or 30 seconds, and/or
b) **in that**, as the high voltage components (1-3) are switched off, the high voltage is reduced in less than 60 seconds to less than 60 V.

4. A motor vehicle, in particular a commercial vehicle, having a high voltage system according to any one of the preceding claims.

5. A monitoring method for a high voltage system, in particular for a high voltage system according to any one of the preceding claims, having the following steps:
a) measure an insulation resistance to earth of high voltage components (1-3) of the high voltage system,
b) monitor the measured insulation resistance of the individual high voltage components (1-3) of the high voltage system by means of a monitoring unit (5), wherein
c) the insulation resistance of the individual high voltage components (1-3) is measured routinely at short time intervals of less than 90 seconds by means of appropriate insulation measuring devices, and
d) the monitoring unit (5) switches off the high voltage components (1-3) if the measured insulation resistance is below a predetermined minimum value, **characterized**
e) **in that** a ring-like monitoring line (6) is provided that issues from the monitoring unit (5) and sequentially connects the latter to the individual high voltage components (1-3) and finally is returned to the monitoring unit (5),
f) **in that** the monitoring unit (5) transmits a query signal by way of the ring-like monitoring line (6),
g) **in that** the monitoring unit (5) checks whether the query signal that is transmitted by the monitoring unit (5) after passing along the ring-like monitoring line (6) is received again by the monitoring unit (5),
h) **in that** the monitoring unit (5) switches off the high voltage components (1-3) if the monitoring unit (5) does not receive the query signal,
i) **in that** the high voltage components (1-3) are connected to one another by wiring harnesses (7, 8), wherein the wiring harnesses (7, 8) each contain a high voltage line (9, 10) and the monitoring line (6), and
j) **in that** the monitoring line (6) is routed through the wiring harnesses (7, 8) between the high voltage components (1-3), so that a fault-related disconnection of the wiring harnesses (7, 8) also results in disconnection of the monitoring line (6).

6. The monitoring method according to Claim 5, **characterized**
a) **in that** the high voltage components (1-3) are each connected by a high voltage plug connection (13-15) to a high voltage line (9, 10), and
b) **in that** the monitoring line (6) is routed through the high voltage plug connections (13-15), so that the monitoring line (6) is broken if at least one of the high voltage plug connections (13-15) is disconnected.

7. The monitoring method according to any one of Claims 5 to 6,
**characterized**
a) **in that** the insulation measuring device measures the insulation resistance routinely at short time intervals of less than 60 or 30 seconds, and/or
b) **in that**, as the high voltage components (1-3) are switched off, the high voltage is reduced in less than 60 seconds to less than 60 V.

## Revendications

1. Système haute tension, en particulier sur un véhicule automobile, comprenant
a) plusieurs composants haute tension (1 à 3) respectivement sous haute tension électrique,
b) plusieurs appareils de mesure d'isolement qui sont chacun réalisés pour mesurer une résistance d'isolement entre l'un des composants haute tension (1 à 3) et la masse, et
c) au moins une unité de surveillance (5) pour surveiller la résistance d'isolement des composants haute tension (1 à 3), dans lequel
d) chaque appareil de mesure d'isolement est réalisé pour mesurer la résistance d'isolement en continu à intervalles rapprochés de moins de 90 secondes, et
e) l'unité de surveillance (5) est réalisée pour mettre hors circuit les composants haute tension (1 à 3) si la résistance d'isolement mesurée soupasse une valeur minimale prédéfinie,
**caractérisé en ce que**
f) une ligne de surveillance annulaire (6) est prévue qui part de l'unité de surveillance (5) et la relie successivement aux composants haute tension (1 à 3) individuels et est finalement ramenée à l'unité de surveillance (5),
g) l'unité de surveillance (5) est réalisée pour envoyer un signal d'interrogation sur la ligne de surveillance annulaire (6),
h) l'unité de surveillance (5) est réalisée pour vérifier si le signal d'interrogation envoyé par l'unité de surveillance (5) est à nouveau reçu par l'unité de surveillance (5) après le passage par la ligne de surveillance annulaire (6),
i) l'unité de surveillance (5) est réalisée pour mettre hors circuit les composants haute tension (1 à 3) si l'unité de surveillance (5) ne reçoit pas le signal d'interrogation,
j) les composants haute tension (1 à 3) sont reliés les uns aux autres par des faisceaux de câbles (7, 8), les faisceaux de câbles (7, 8) contenant respectivement une ligne haute tension (9, 10) et la ligne de surveillance (6), et
k) la ligne de surveillance (6) est posée à travers les faisceaux de câbles (7, 8) entre les composants haute tension (1 à 3) de telle sorte qu'une déconnexion, due à un défaut, des faisceaux de câbles (7, 8) entraîne aussi une déconnexion de la ligne de surveillance (6).

2. Système haute tension selon la revendication 1, **caractérisé en ce que**
a) les composants haute tension (1 à 3) sont chacun connectés par un connecteur haute tension (13 à 15) à une ligne haute tension (9, 10), et
b) la ligne de surveillance (6) est posée à travers les connecteurs haute tension (13 à 15) de telle sorte que la ligne de surveillance (6) est coupée si au moins l'un des connecteurs haute tension (13 à 15) est déconnecté.

3. Système haute tension selon l'une quelconque des revendications précédentes, **caractérisé en ce que**
a) chaque appareil de mesure d'isolement est réalisé pour mesurer la résistance d'isolement en continu à intervalles rapprochés de moins de 60 ou 30 secondes, et/ou
b) à la mise hors circuit des composants haute tension (1 à 3), la haute tension est réduite à moins de 60 V en moins de 60 secondes.

4. Véhicule automobile, en particulier véhicule utilitaire, comprenant un système haute tension selon l'une quelconque des revendications précédentes.

5. Procédé de surveillance pour un système haute tension, en particulier pour un système haute tension selon l'une quelconque des revendications précédentes, comprenant les étapes suivantes consistant à :
a) mesurer une résistance d'isolement par rapport à la masse, des composants haute tension (1 à 3) du système haute tension,
b) surveiller la résistance d'isolement mesurée des composants haute tension (1 à 3) individuels du système haute tension par une unité de surveillance (5), dans lequel
c) la résistance d'isolement des composants haute tension (1 à 3) individuels est mesurée en continu à intervalles rapprochés de moins de 90 secondes par des appareils de mesure d'isolement correspondants, et
d) l'unité de surveillance (5) met hors circuit les composants haute tension (1 à 3) si la résistance d'isolement mesurée soupasse une valeur minimale prédéfinie,
**caractérisé en ce que**
e) une ligne de surveillance annulaire (6) est prévue qui part de l'unité de surveillance (5) et la relie successivement aux composants haute tension (1 à 3) individuels et est finalement ramenée à l'unité de surveillance (5),
f) l'unité de surveillance (5) envoie un signal d'interrogation sur la ligne de surveillance annulaire (6),
g) l'unité de surveillance (5) vérifie si le signal d'interrogation envoyé par l'unité de surveillance (5) est à nouveau reçu par l'unité de surveillance (5) après le passage par la ligne de surveillance annulaire (6),
h) l'unité de surveillance (5) met hors circuit les composants haute tension (1 à 3) si l'unité de surveillance (5) ne reçoit pas le signal d'interrogation,
i) les composants haute tension (1 à 3) sont reliés les uns aux autres par des faisceaux de câbles (7, 8), les faisceaux de câbles (7, 8) contenant respectivement une ligne haute tension (9, 10) et la ligne de surveillance (6), et
j) la ligne de surveillance (6) est posée à travers les faisceaux de câbles (7, 8) entre les composants haute tension (1 à 3) de telle sorte qu'une déconnexion, due à un défaut, des faisceaux de câbles (7, 8) entraîne aussi une déconnexion de la ligne de surveillance (6).

6. Procédé de surveillance selon la revendication 5, **caractérisé en ce que**
a) les composants haute tension (1 à 3) sont chacun connectés par un connecteur haute tension (13 à 15) à une ligne haute tension (9, 10), et
b) la ligne de surveillance (6) est posée à travers les connecteurs haute tension (13 à 15) de telle sorte que la ligne de surveillance (6) est coupée si au moins l'un des connecteurs haute tension (13 à 15) est déconnecté.

7. Procédé de surveillance selon l'une quelconque des revendications 5 à 6, **caractérisé en ce que**
a) l'appareil de mesure d'isolement mesure la résistance d'isolement en continu à intervalles rapprochés de moins de 60 ou 30 secondes, et/ou
b) à la mise hors circuit des composants haute tension (1 à 3), la haute tension est réduite à moins de 60 V en moins de 60 secondes.
